# FASCICULE DE BREVET EUROPEEN

(11) **EP 3 985 438 B1**
(45) Date de publication et mention de la délivrance du brevet: **05.03.2025**
(21) Numéro de dépôt: 21200411.3
(22) Date de dépôt: 01.10.2021
(51) Int. Cl.: G03F 1/38, G03F 7/20, H01L 23/485, H01L 23/544, H05K 1/02

(54) **PROCEDE DE FABRICATION D'UN ENSEMBLE DE COMPOSANTS ELECTRONIQUES SUR LA FACE AVANT D'UN SUBSTRAT SEMI-CONDUCTEUR**
VERFAHREN ZUR HERSTELLUNG EINER ELEKTRONISCHEN BAUGRUPPE AUF DER VORDERSEITE EINES HALBLEITERSUBSTRATS
METHOD FOR MANUFACTURING A SET OF ELECTRONIC COMPONENTS ON THE FRONT FACE OF A SEMICONDUCTOR SUBSTRATE

(30) Priorité: 16.10.2020 FR 2010601
(43) Date de publication de la demande: 20.04.2022
(73) Titulaire: STMicroelectronics France, 92120 Montrouge (FR)
(72) Inventeur: NONGAILLARD, Matthieu, 38000 GRENOBLE (FR); OHEIX, Thomas, 38000 GRENOBLE (FR)
(74) Mandataire: Cabinet Beaumont

(56) Documents cités:
- JP-A- H0 378 224
- US-A1- 2007 148 599
- US-A1- 2009 315 193
- US-A1- 2013 299 939
- US-B2- 8 187 897

## Description

### DOMAINE DE L'INVENTION

La présente invention concerne le domaine des semi-conducteurs. Plus précisément, la présente invention porte sur un procédé de fabrication d'un ensemble de composants électroniques sur un substrat semi-conducteur, permettant, après singularisation des composants, de remonter à la localisation de ces composants sur le substrat, du fait de la présence sur chaque composant d'un élément d'identification.

### ARRIERE PLAN TECHNOLOGIQUE DE L'INVENTION

Dans l'industrie des semi-conducteurs, il est habituel de fabriquer collectivement un ensemble de composants électroniques identiques sur un substrat semi-conducteur. Pour élaborer les empilements de couches formant les composants électroniques sur le substrat, on recourt notamment à des étapes de photolithographie, lesquelles permettent de structurer certaines couches dudit empilement. En pratique, une couche de matériau est déposée sur la totalité du substrat, puis une photorésine est déposée sur la couche. Un masque photolithographique est alors appliqué au-dessus de la couche, successivement sur chaque champ d'exposition, et toute la partie non couverte par le masque est exposée à la lumière, transformant localement la photorésine. La résine transformée est ensuite retirée, et la couche est localement gravée selon le motif du masque, sur toute la surface du substrat semi-conducteur, avant que la photorésine subsistante ne soit à son tour retirée. Des étapes de nettoyage, de polissage et/ou de traitements thermiques peuvent également être réalisées entre ces étapes. Le processus est ainsi répété pour une pluralité de couches de l'empilement, en utilisant à chaque fois un masque photolithographique différent.

Lorsque l'ensemble des composants électroniques est formé sur le substrat, celui-ci est découpé autour de chaque composant, pour former une puce qui est ensuite individuellement encapsulée dans un boîtier. Habituellement, les équipements de préhension et transfert des puces (« pick-and-place » selon la terminologie anglo-saxonne) assurent informatiquement la correspondance entre chaque puce (composant) et le substrat semi-conducteur dont elle provient.

Mais en cas de défaillance d'un composant, il peut être souhaitable de remonter à la localisation précise du composant électronique sur le substrat, de manière à vérifier les paramètres physiques des couches lors de la fabrication dans la zone correspondante du substrat et à faciliter l'analyse de défaillance.

La traçabilité du composant électronique peut être réalisée au moment de l'assemblage, c'est-à-dire lorsque le composant est encapsulé, avec un marquage spécifique sur le boîtier. Toutefois, cette opération, souvent réalisée par un opérateur manuel, entraîne des coûts et un temps de production importants. En outre, elle n'est pas adaptée si le composant n'est pas encapsulé dans un boîtier, et est peu adaptée à la production de masse.

Certaines lignes d'assemblage proposent une solution semi-manuelle, mettant en œuvre un prélèvement, la constitution d'un fichier de correspondance entre la position du composant sur le substrat et le numéro du boîtier, ainsi qu'une sérialisation du boîtier, suivie par l'opérateur. Toutefois, toutes ces opérations nécessitent l'intervention d'opérateurs humains, ce qui peut être source d'erreur.

Le document US8187897 présente un procédé de fabrication d'un ensemble de composants électroniques sur un substrat semi-conducteur. Un motif individuel est apposé sur l'une des couches du composant électronique, qui constitue un identifiant unique du composant permettant de tracer le substrat dont il est issu ainsi que sa position sur le substrat.

Toutefois, cette approche présente l'inconvénient d'une certaine complexité de mise en œuvre, notamment en ce qu'il nécessite l'application de masques photolithographiques supplémentaires par rapport à un procédé classique de fabrication d'un ensemble de composants, ces masques supplémentaires étant requis pour générer un motif spécifique pour chaque composant. L'ajout de masques photolithographiques entraîne en outre un coût et un temps de production additionnels.

Le document US 2013/0299939 décrit un motif d'identification de puce et son procédé d'obtention.

### OBJET DE L'INVENTION

La présente invention concerne une solution alternative à celles de l'état de la technique, et vise à remédier à tout ou partie des inconvénients précités. Elle concerne en particulier un procédé de fabrication d'un ensemble de composants électroniques sur un substrat semi-conducteur permettant la localisation de chaque composant électronique sur le substrat après sa découpe, sans nécessiter d'étape photolithographique supplémentaire lors de l'élaboration de l'ensemble de composants électroniques.

### BREVE DESCRIPTION DE L'INVENTION

L'invention concerne un procédé tel que défini dans les revendications.

### BREVE DESCRIPTION DES FIGURES

D'autres caractéristiques et avantages de l'invention ressortiront de la description détaillée de l'invention qui va suivre en référence aux figures annexées sur lesquels :
La figure 1 présente une structure électronique composée d'un ensemble de composants électroniques disposés sur la face avant d'un substrat semi-conducteur, obtenue par un procédé de fabrication conforme à l'invention ;
La figure 2a présente un alignement de motifs classiquement opéré entre un niveau de masque Lₙ et un niveau de masque de référence L_{ref} ;
La figure 2b présente plusieurs possibilités de décalage prédéterminé D_{ZC} entre les motifs d'un niveau de masque d'identification Lᵢ et les motifs d'un niveau de masque de référence L_{ref}, ledit décalage prédéterminé D_{ZC} étant opéré lors d'une étape de photolithographie du procédé de fabrication conforme à l'invention ;
La figure 2c présente un exemple de mise en œuvre du procédé de fabrication conforme à l'invention, avec des décalages prédéterminés D_{ZC} appliqués à chaque zone de champ ZC1, ZC2, ZC3, ZC4, ZC5 du substrat sur lequel sont élaborés les composants électroniques ;
La figure 3a présente un alignement de marques classiquement opéré entre un niveau de masque Lₙ et un niveau de masque de référence L_{ref} ;
La figure 3b présente des possibilités de décalage prédéterminé D_{ZC} entre la marque d'alignement d'un niveau de masque d'identification Lᵢ et la marque d'alignement d'un niveau de masque de référence L_{ref}, ledit décalage prédéterminé étant opéré lors d'une étape de photolithographie du procédé de fabrication conforme à l'invention.

Les figures sont des représentations schématiques qui, dans un objectif de lisibilité, ne sont pas nécessairement à l'échelle. Les mêmes références sur les figures pourront être utilisées pour des éléments de même nature. Les différentes possibilités (variantes et modes de réalisation illustrés et/ou détaillés dans la description à suivre) doivent être comprises comme n'étant pas exclusives les unes des autres et peuvent se combiner entre elles.

### DESCRIPTION DETAILLEE DE L'INVENTION

L'invention concerne un procédé de fabrication d'un ensemble de composants électroniques. On entend par composant électronique tout composant de taille micrométrique à millimétrique, constitué d'un empilement de couches, capable d'utiliser des courants électriques pour transmettre, traiter ou stocker des informations. Chaque composant électronique peut ainsi être constitué ou comprendre par exemple une résistance, un condensateur, une bobine, un transistor, un circuit intégré, toute combinaison ou tout assemblage de ces éléments, ou bien encore d'autres éléments ou assemblages d'éléments bien connus de l'homme du métier. De préférence, mais sans que cela ne soit limitatif de l'invention, les composants électroniques peuvent notamment comprendre des transistors à haute mobilité électronique élaborés sur un substrat à base de matériaux III-N.

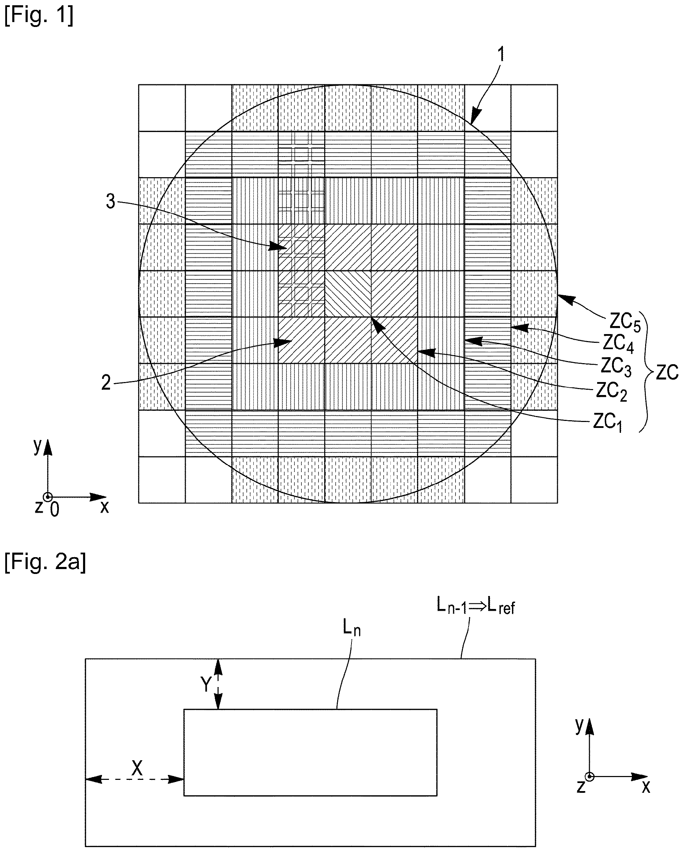

Plus généralement, les composants électroniques 3 sont formés sur une face avant d'un substrat semi-conducteur 1 (figure 1). Le substrat 1 se présente préférentiellement sous la forme d'une plaquette circulaire, de diamètre compris entre 100 mm et 450 mm et d'épaisseur comprise entre 100 et 1500 microns. Le substrat semi-conducteur 1 peut comprendre tout matériau semi-conducteur, par exemple du silicium et plus spécifiquement, comme énoncé précédemment, un empilement de matériaux III-N binaires, ternaires ou quaternaires, tels que par exemple le nitrure de gallium (GaN), du nitrure de gallium aluminium (AlGaN), etc. Bien entendu, l'invention n'est aucunement limitée à de telles formes, dimensions ou composition du substrat semi-conducteur 1.

La face avant du substrat semi-conducteur 1 s'étend dans un plan principal (x,y) et l'empilement de couches formant les composants électroniques est élaboré selon un axe z normal à ce plan (x,y). L'élaboration de cet empilement requiert une succession d'étapes de production, à savoir des étapes de dépôt de couche, de lithographie pour définir la structuration de ladite couche, de gravure pour structurer la couche, de traitements de surface, etc.

Comme cela a été rappelé dans la partie introductive de la présente demande, lors d'une étape de photolithographie, l'application du masque photolithographique correspondant à l'étape, et l'exposition à la lumière, sont opérées champ 2 par champ 2. Un champ 2 (également appelé champ d'exposition 2) peut comprendre un seul composant électronique 3 ou une pluralité de composants électroniques 3, typiquement entre deux et plusieurs centaines. Par souci de simplification sur la figure 1, des composants 3 n'ont été représentés que sur quatre champs 2, en l'occurrence neuf composants 3 par champ 2.

Comme cela est visible sur la figure 1, la face avant du substrat semi-conducteur 1 présente une pluralité de zones de champ ZC (l'exemple de la figure 1 représente schématiquement cinq zones de champs ZC1, ZC2, ZC3, ZC4, ZC5). Chaque zone de champ ZC comprend un champ 2 ou une pluralité de champs 2.

De manière générale, le nombre et la répartition des champs 2 dans chaque zone de champ ZC peuvent être identiques pour toutes les zones 4, ou différents d'une zone à l'autre.

Comme cela sera décrit ultérieurement, l'invention prévoit la possibilité de regrouper plusieurs champs 2 en zones de champ ZC, de telle sorte que les champs 2 d'une même zone ZC aient des caractéristiques similaires, tandis que les champs 2 de zones ZC différentes présentent des caractéristiques différentes reconnaissables.

Sur l'exemple schématique de la figure 1, la première zone ZC1 comprend un unique champ, positionné au centre du substrat semi-conducteur 1. La deuxième zone ZC2 comprend huit champs, la troisième zone ZC3 comprend seize champs, la quatrième zone ZC4 comprend vingt-quatre champs, et la cinquième zone ZC5 comprend vingt champs. Par souci de simplification, les composants 3 par champ 2 ont été représentés uniquement sur deux champs de la deuxième zone ZC2 et sur un champ des troisième ZC3 et quatrième ZC4 zones de champ.

La forme et la taille des zones de champ ZC peuvent être librement choisies, dans la limite du fait qu'elles sont composées d'un ou plusieurs champs 2. Préférentiellement, lorsque le substrat semi-conducteur 1 est circulaire, les zones ZC peuvent être choisies de manière à être concentriques, comme sur l'exemple de la figure 1. Alternativement, chaque zone ZC peut s'étendre sur un quartier du substrat semi-conducteur 1, par exemple la moitié ou un quart dudit substrat. De manière générale, les zones ZC peuvent s'étendre sur toutes portions du substrat 1 comprenant une ou plusieurs champs contigus ou non.

Revenant au procédé de fabrication selon l'invention, un tel procédé comprend une pluralité d'étapes de photolithographie pour former un empilement de couches constituant chaque composant électronique 3. Ces étapes, spécifiquement définies pour former ledit empilement de couches, sont des étapes de photolithographie de production. Ces étapes de photolithographie sont entrecoupées d'autres étapes bien connues permettant la formation de l'empilement, telles que des étapes de traitement thermique, de dépôt, de gravure, de nettoyage, de dopage ou de polissage. Les différentes étapes de formation d'un empilement constituant un composant électronique sont tout à fait classiques et connues de l'homme du métier et ne seront que succinctement rappelées ci-après.

Les étapes de traitement thermique sont typiquement effectuées à des températures comprises entre 200°C et 1200°C, notamment pour réaliser des couches d'oxyde ou de nitrure de silicium, pour dégazer des couches ou pour opérer un réarrangement des réseaux cristallins.

Les étapes de dépôt peuvent être effectuées par diverses techniques physiques ou chimiques connues, telles que le dépôt en phase vapeur, la pulvérisation, ou l'épitaxie par exemple, en fonction du type de couches souhaité et de la compatibilité notamment en température de l'empilement. Les couches déposées peuvent être de natures diverses : semi-conductrices, isolante ou conductrices.

Les étapes de gravure peuvent être réalisées dans des bains de solutions chimiques (gravure humide) ou dans des équipements de gravure par plasma ou par ions réactifs (gravure sèche). Les étapes de nettoyage sont habituellement opérées dans des bains chimiques.

Des étapes de traitements de surface, telles que le polissage mécano-chimique, peuvent également être appliquées à l'empilement de couches pour planariser certaines couches ou éliminer des surépaisseurs locales.

Au cours de chaque étape de photolithographie, le substrat semi-conducteur 1 est disposé dans un équipement de photolithographie (non représenté). Après qu'une couche de photorésine ait été déposée sur la face avant du substrat 1, chaque étape de photolithographie comprend l'application d'un masque successivement sur chaque champ 2. Lorsqu'il est appliqué sur un champ 2, ce dernier est exposé à une source lumineuse de faible longueur d'onde, généralement ultraviolet ou rayons X, afin de projeter l'image du masque dans la couche de photorésine, définissant ainsi des motifs dans la couche de photorésine.

Des étapes de gravures permettent ensuite de reproduire le motif de la couche de photorésine dans la couche de l'empilement située en-dessous et ainsi de structurer cette dernière. Les motifs peuvent consister par exemple en un arrangement de doigts interdigités pour former les électrodes de grille, de source et de drain d'un transistor, ou en un réseau d'ouvertures pour former des vias d'interconnexion conducteurs électriques, ou encore en une pluralité de plots de contact destinés à connecter chaque composant 3. Dans tous les cas, les motifs sont fonctionnels, c'est-à-dire que leur forme et leur disposition sont définies pour rendre fonctionnel le composant électronique 3.

A titre d'exemple, lorsque le composant électronique 3 comprend un transistor, l'empilement de couche comprend une couche active semi-conductrice, sur laquelle sont superposées une pluralité de couches d'interconnexion formée typiquement d'une alternance de couches uniformes ou structurées, isolantes et métalliques, et enfin d'une couche supérieure de passivation.

Il est habituel de parler de niveau de masque Lₙ, pour qualifier les motifs définis par une étape photolithographique dans une couche n de l'empilement. Les premiers niveaux de masque (L₁, L₂, L₃, ... ), qui visent à structurer la couche active du substrat semi-conducteur 1, sont associés à des masques (m₁, m₂, m₃, ...) formant des motifs de très petites dimensions (typiquement de l'ordre de la dizaine ou la centaine de nanomètres) et requérant une haute résolution à l'étape photolithographique. Outre la précision de définition des motifs sur le masque lui-même, cette haute résolution inclut le fait de positionner (dans le plan principal (x,y)) le masque mₙ du niveau de masque Lₙ très précisément par rapport au niveau de masque Lₙ₋₁ précédent. Une étape photolithographique requiert donc généralement un alignement précis entre les niveaux de masque Lₙ successifs. Cet alignement est réalisé grâce à des croix et/ou marques d'alignement respectivement présentes sur les masques mₙ et imprimées dans les couches aux différents niveaux de masque Lₙ-₁, qui permettent de positionner le masque mₙ sur un champ 2 relativement à un niveau de masque précédent (correspondant à une couche inférieure dans l'empilement de couches).

En pratique, le positionnement (dans le plan principal (x,y)) des masques successifs est opéré par rapport à un niveau de masque de référence L_{ref}, qui peut être le premier niveau de masque mis en œuvre dans l'empilement de couche ou plus généralement, un niveau de masque précédent.

Plus les niveaux de masque Lₙ sont élevés (typiquement, pour structurer les couches d'interconnexion métalliques ou ouvrir les contacts des composants électroniques), plus les masques mₙ forment des motifs de grandes dimensions : par exemple, pour le dernier étage de métallisation de l'empilement de couches d'un composant électronique de type transistor à effet de champ, les motifs peuvent mesurer de l'ordre de quelques dizaines à plusieurs centaines de microns.

Dans le procédé de fabrication conforme à l'invention, un masque mₙ utilisé au cours de l'une des étapes de photolithographie de production, est désigné « masque d'identification » mᵢ dans la présente description. Le niveau de masque Lᵢ associé au masque d'identification mᵢ est appelé par la suite niveau de masque d'identification Lᵢ.

Ainsi, selon l'invention, à l'étape de photolithographie définissant le niveau de masque Lᵢ associé au masque d'identification mᵢ, ledit masque mᵢ est positionné, dans le plan principal (x,y), avec un décalage prédéterminé D_{zc} par rapport au niveau de masque de référence L_{ref} et le décalage D_{zc} est différent pour chaque zone de champ ZC.

Le ou les composant(s) électronique(s) 3 d'une zone de champ ZC présente(nt) alors un élément d'identification se traduisant par un décalage prédéterminé D_{zc}, dans le plan principal (x,y), entre un motif défini au niveau de masque de référence L_{ref} et un motif défini au niveau de masque d'identification Lᵢ.

De la sorte, après la découpe des composants électroniques 3, il est possible de reconnaître la zone de champ ZC du substrat 1 d'où provient chaque composant 3 en mesurant le décalage prédéterminé D_{ZC} entre un motif défini au niveau de masque de référence L_{ref} et un motif défini au niveau de masque d'identification Lᵢ. Le procédé de fabrication selon l'invention permet donc, sans réaliser d'étape de photolithographie supplémentaire (c'est-à-dire en effectuant uniquement les étapes de photolithographie de production), et notamment sans masque supplémentaire à appliquer, d'identifier la localisation de composants 3 par zone ZC du substrat semi-conducteur 1, par la variation maîtrisée du décalage entre le niveau de masque d'identification Lᵢ et le niveau de masque de référence L_{ref}, d'une zone de champ ZC à une autre.

Dans l'exemple représenté sur la figure 1, les composants 3 dans les champs 2 de la deuxième zone de champ ZC2 présenteront un élément d'identification identique, correspondant à un décalage prédéterminé D_{ZC2}, mais différent des éléments d'identification des composants 3 dans les champs 2 des autres zones de champ ZC1, ZC3, ZC4, ZC5, eux-mêmes différents entre eux.

Avantageusement, afin de pouvoir repérer et caractériser de manière fiable l'élément d'identification, pour chaque zone de champ ZC, le décalage prédéterminé D_{zc} varie entre un décalage minimum, détectable optiquement, et un décalage maximum, susceptible de dégrader la performance des composants électroniques 3. En effet, si le décalage entre le niveau de masque d'identification Lᵢ et le niveau de masque de référence L_{ref} est trop important, les motifs fonctionnels présents dans le niveau de masque d'identification Lᵢ ne seront plus correctement disposés dans l'empilement de couches pour conférer aux composants électroniques les caractéristiques électriques recherchées. Bien sûr, le décalage maximum va dépendre du niveau de masque Lₙ choisi pour constituer le niveau de masque d'identification Lᵢ.

Des exemples de décalages minimum et maximum sont donnés ci-après, en référence à différents choix de niveau de masque d'identification Lᵢ.

Selon un mode de réalisation avantageux, afin de ne pas intervenir sur les couches les plus sensibles et fonctionnelles de l'empilement, associées aux premiers niveaux de masque, le masque d'identification mᵢ correspond au masque appliqué à l'étape de photolithographie pour l'ouverture de contacts des composants électroniques 3. C'est typiquement la dernière étape de photolithographie (dernier niveau de masque) qui est opérée sur l'empilement de couches du substrat 1. Elle consiste à définir des ouvertures dans la couche supérieure de passivation de l'empilement, en vis-à-vis des plots de contact électrique de chaque composant 3, pour donner accès à une connexion électrique du composant 3 vers l'extérieur.

Dans ce mode de réalisation, le niveau de masque de référence L_{ref} est préférentiellement défini par une étape de photolithographie, antérieure à celle pour l'ouverture de contacts, opérée pour la formation d'une dernière couche de métallisation de l'empilement de couches : le niveau de masque défini par cette étape est habituellement nommé « dernier niveau de métal ».

La figure 2a illustre un alignement standard, habituellement réalisé entre un niveau de masque Lₙ et le niveau de masque de référence L_{ref}. Le motif du niveau de masque supérieur Lₙ est centré sur le motif du niveau de masque inférieur Lₙ₋₁ (L_{ref} dans ce cas particulier). Dans le mode de réalisation avantageux précité, le niveau de masque inférieur Lₙ₋₁ est le dernier niveau de métal : les motifs associés correspondent aux plots métalliques de contact. Le niveau de masque Lₙ supérieur est le niveau d'ouverture des contacts : les motifs associés correspondent à la fenêtre devant être ouverte pour donner l'accès aux plots métalliques de contact sous-jacents.

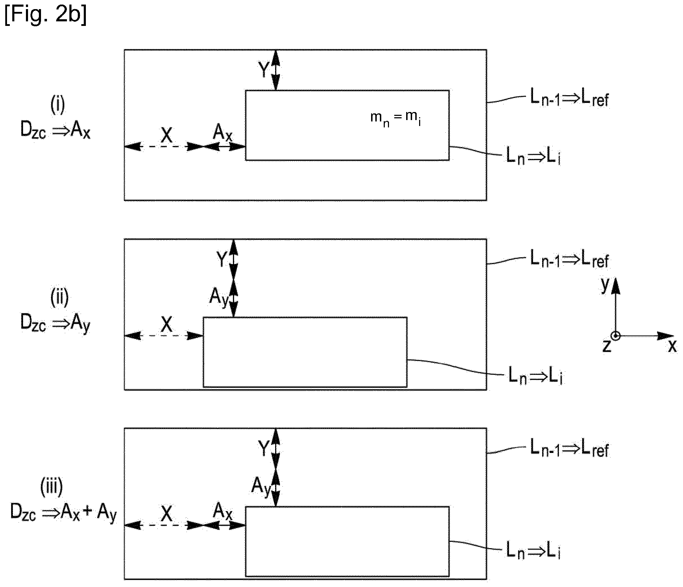

La figure 2b présente plusieurs décalages prédéterminés possibles D_{ZC}, opérés lors de l'application du masque d'identification mᵢ correspondant au niveau de masque d'ouverture des contacts (Lᵢ sur la figure). Les décalages prédéterminés D_{zc} sont caractérisés :
- par une première amplitude de décalage Aₓ selon un premier axe x dans le plan principal (x,y) parallèle à la face avant du substrat 1 (fig.2b (i)), ou
- par une deuxième amplitude de décalage A_{y} selon un deuxième axe y dans le plan principal (x,y) parallèle à la face avant du substrat 1 (fig.2b (ii)), ou encore
- par une première amplitude Aₓ et une deuxième amplitude A_{y} de décalage, respectivement selon le premier axe x et le deuxième axe y dans le plan principal (x,y) (fig.2b (iii)).

Les amplitudes de décalage Aₓ, A_{y} représentent les déviations par rapport à un alignement standard du masque d'identification mᵢ sur le niveau de masque de référence L_{ref}, dans le champ 2 traité. L'alignement standard correspond à des espacements X et Y, entre les motifs de deux niveaux de masque, respectivement selon les axes x et y, comme illustré sur la figure 2a. Il est bien sûr requis d'appliquer des amplitudes de décalage mesurables et reconnaissables : ces dernières doivent donc être supérieures aux incertitudes d'alignement et de centrage habituellement rencontrées entre les niveaux de masque considérés.

Notons que ces amplitudes de décalage Aₓ, A_{y} sont prédéfinies pour chaque zone de champ ZC et enregistrées dans l'équipement de photolithographie, qui va les implémenter automatiquement lors de l'application du masque d'identification mᵢ (niveau de masque Lᵢ) sur chaque champ 2, en fonction de la zone de champ ZC à laquelle il appartient.

Dans le mode de réalisation avantageux décrit, les dimensions latérales des contacts des composants 3 au dernier niveau de métal (niveau de masque de référence L_{ref}) sont typiquement comprises entre 50 et 5000 microns ; les dimensions latérales de la fenêtre d'ouverture dans la couche supérieure de passivation, qui doit être définie au niveau de masque d'ouverture des contacts (niveau de masque d'identification Lᵢ), sont typiquement de l'ordre de 30 à 3000 microns. Ainsi, il est possible d'appliquer des décalages prédéterminés D_{zc} dont la première Aₓ et/ou la deuxième A_{y} amplitude de décalage est (sont) comprise(s) par exemple entre 1 micron et 100 microns, entre les motifs du niveau de masque de référence L_{ref} et les motifs du niveau de masque d'identification Lᵢ comme illustré sur la figure 2b.

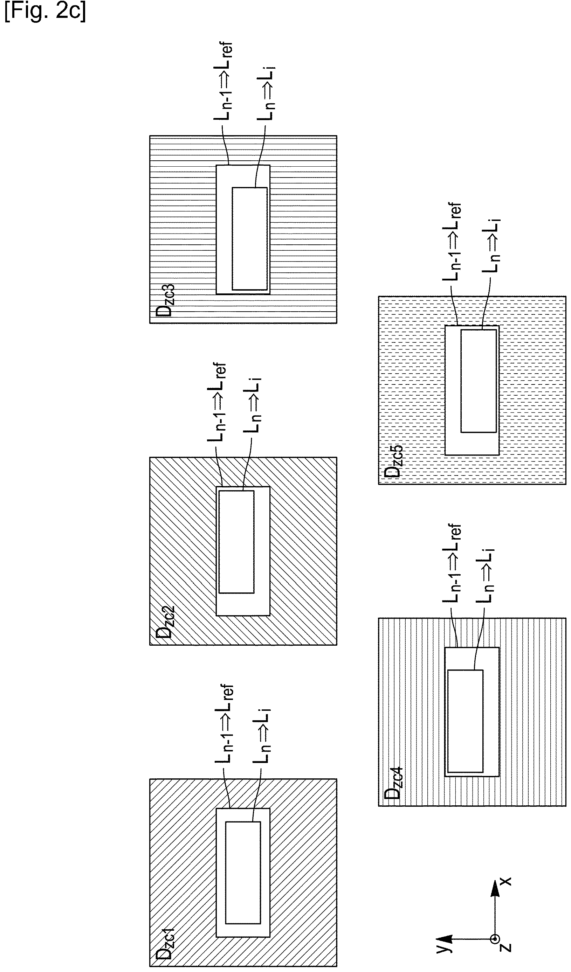

En référence au mode de réalisation précité, un exemple de mise en œuvre est présenté en figure 2c. Les zones de champ ZC sont celles définies sur la figure 1 et les décalages prédéterminés D_{zc}, associés à chaque zone de champ ZC sont les suivants :
- : Aₓ = 0, A_{y} = 0 ;
- D_{zc2} : Ax = +10 microns, Ay = +10 microns ;
- D_{zc3} : Ax = -10 microns, Ay = -10 microns ;
- D_{zc4} : Ax = -10 microns, Ay = +10 microns ;
- D_{zc5} : Ax = +10 microns, Ay = -10 microns ;

La valeur de 10 microns pour les première Aₓ et deuxième A_{y} amplitudes de décalage est donnée ici de manière arbitraire : ces amplitudes pourraient prendre des valeurs différentes comprises entre 1 et 100 microns. Les valeurs négatives indiquent un décalage, par rapport à l'alignement standard, dans le sens inverse de l'axe x ou y considéré.

Après singularisation des composants électroniques sous forme de puces individuelles, il sera possible de remonter pour chaque composant, à sa zone de champ ZC d'origine sur le substrat 1, uniquement par observation et mesure du décalage prédéterminé D_{zc} entre les motifs du dernier niveau de métal (niveau de masque de référence L_{ref}) et les motifs du niveau d'ouverture des contacts (niveau de masque d'identification Lᵢ). Ce décalage forme un élément d'identification n'apportant aucune complexification au procédé de fabrication de l'ensemble de composants 3 sur le substrat 1.

Selon un autre exemple de mise en œuvre, les zones de champ ZC comprennent un seul champ 2. Compte tenu du plus grand nombre de zones de champ ZC, les décalages prédéterminés D_{zc} associés à chaque zone ZC sont définis plus finement que dans le cas précédent avec cinq zones de champ ZC. On pourra par exemple choisir de faire évoluer les amplitudes Aₓ et A_{y} de manière croissante au fur et à mesure que l'on s'éloigne du champ central.

Après singularisation des composants électroniques 3 sous forme de puces individuelles, il sera possible de remonter pour chaque composant, à sa zone de champ ZC d'origine sur le substrat 1, uniquement par observation et mesure du décalage prédéterminé D_{zc} entre les motifs du dernier niveau de métal (niveau de masque de référence L_{ref}) et les motifs du niveau d'ouverture des contacts (niveau de masque d'identification Lᵢ). Cet exemple de mise en œuvre procure une finesse supplémentaire sur la localisation d'origine des composants 3 car chaque zone de champ ZC ne comprend qu'un seul champ. Dans le cas où chaque champ 2 comprend un composant 3 unique, il est donc possible de remonter à la localisation d'origine de chaque composant grâce à l'élément d'identification.

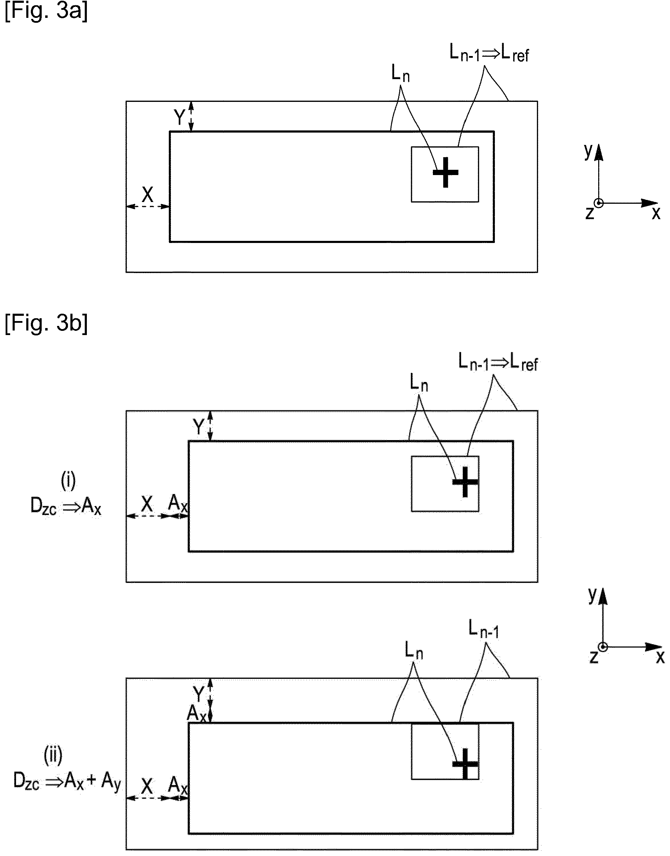

Selon une variante, le décalage prédéterminé D_{zc} peut être défini entre des marques ou croix d'alignement et non directement entre des motifs fonctionnels des niveaux de masque considérés. Comme illustré sur la figure 3a, le motif du niveau de masque supérieur Lₙ est centré sur le motif du niveau de masque inférieur Lₙ₋₁, du fait du centrage de la croix dans le carré, ces derniers formant les marques d'alignement respectives des deux niveaux de masque. Les décalages prédéterminés D_{zc} peuvent être appliqués aux marques d'alignement (figure 3b i) et ii)).

L'élément d'identification est alors présent au niveau de la couche supérieure de passivation de l'empilement, et présente l'avantage d'être visible dans le cadre d'un contrôle visuel. Une observation au microscope optique du composant singularisé peut ainsi permettre de remonter à la localisation d'origine de celui-ci sur le substrat semi-conducteur 1. Bien entendu, d'autres méthodes optiques que la simple observation au microscope optique peuvent être employées pour analyser les éléments d'identification, comme une analyse optique au moyen d'un logiciel de reconnaissance de motifs par exemple.

Selon d'autres modes de réalisation, le(s) masque(s) d'identification correspond(ent) au(x) masque(s) appliqué(s) à l'étape de photolithographie pour n'importe quel niveau de masques. Le décalage prédéterminé D_{zc} est alors adapté aux motifs des niveaux de masque d'identification Lᵢ et de référence L_{ref}.

La présente invention concerne également une structure électronique composée d'un ensemble de composants électroniques 3 disposés sur la face avant d'un substrat semi-conducteur 1, et pouvant être élaborée à partir du procédé de fabrication décrit précédemment.

Le substrat semi-conducteur 1 présente une pluralité de zones de champ ZC. Chaque zone ZC comprend au moins un champ 2 et chaque champ 2 comprend au moins un composant électronique 3. Chaque composant électronique 3 est constitué d'un empilement de couches. Chaque composant 3 comprend en outre un élément d'identification se traduisant par un décalage prédéterminé D_{zc} entre :
- un motif, défini à un niveau de masque de référence L_{ref} lors d'une étape de photolithographie du procédé de fabrication de la structure, dans une couche de l'empilement constituant ledit composant 3, et
- un motif, défini à un niveau de masque d'identification Lᵢ lors d'une étape de photolithographie ultérieure du procédé de fabrication de la structure, dans une autre couche de l'empilement.

Le décalage prédéterminé est différent selon les zones de champ ZC : un décalage particulier est donc représentatif d'une zone de champ ZC de la structure électronique.

L'élément d'identification est donc reconnaissable et distinct pour chaque zone de champ ZC, ce qui permet, une fois la découpe de la structure électronique autour de chaque composant électronique 3 réalisée, de pouvoir identifier si besoin la zone de champ ZC du substrat 1 de laquelle le composant électronique 3 est issu.

Bien entendu l'invention n'est pas limitée aux modes de mise en œuvre décrits et on peut y apporter des variantes de réalisation sans sortir du cadre de l'invention tel que défini par les revendications.

## Revendications

1. Procédé de fabrication d'un ensemble de composants électroniques (3) sur une face avant d'un substrat semi-conducteur (1) présentant une pluralité de zones de champ (ZC), chaque zone de champ (ZC) comprenant au moins un champ (2) et chaque champ (2) comprenant au moins un composant électronique (3), le procédé comprenant une pluralité d'étapes de photolithographie pour former un empilement de couches constituant chaque composant électronique (3), parmi lesquelles une étape de photolithographie pour une ouverture de contacts des composants électroniques (3), chaque étape de photolithographie définissant un niveau de masque (Lₙ) et comprenant l'application d'un masque (mₙ) successivement sur chaque champ (2) dans un équipement de photolithographie, le positionnement dudit masque (mₙ) sur chaque champ (2) étant opéré relativement à un niveau de masque de référence (L_{ref}), l'un des masques (mₙ) étant désigné masque d'identification (mᵢ) ;
le procédé de fabrication étant **caractérisé en ce que** :
- le masque appliqué à l'étape de photolithographie pour l'ouverture de contacts correspond au masque d'identification (mᵢ),
- à l'étape de photolithographie pour l'ouverture de contacts, définissant un niveau de masque (Lᵢ) associé au masque d'identification (mᵢ), ledit masque (mᵢ) est positionné avec un décalage prédéterminé (D_{zc}) par rapport au niveau de masque de référence (L_{ref}), le décalage (D_{zc}) étant différent pour chaque zone de champ (ZC),
- le ou les composant(s) électronique(s) (3) d'une zone de champ (ZC) présente(nt) un élément d'identification se traduisant par un décalage prédéterminé (D_{zc}) entre un motif défini au niveau de masque de référence (L_{ref}) et un motif défini au niveau de masque d'identification (Lᵢ)

2. Procédé de fabrication selon la revendication précédente, dans lequel le décalage prédéterminé (D_{zc}) varie entre un décalage minimum détectable optiquement et un décalage maximum susceptible de dégrader la performance des composants électroniques.

3. Procédé de fabrication selon la revendication précédente, dans lequel le décalage prédéterminé (D_{zc}) comprend une première amplitude de décalage (Aₓ) selon un premier axe (x) d'un plan principal (x,y) parallèle à la face avant du substrat (1), et/ou une deuxième amplitude de décalage (A_{y}) selon un deuxième axe (y) du plan principal (x,y).

4. Procédé de fabrication selon l'une des revendications précédentes, dans lequel le niveau de masque de référence (L_{ref}) est défini par une étape de photolithographie, antérieure à celle pour l'ouverture de contacts, pour la formation d'une dernière couche de métallisation de l'empilement de couches constituant chaque composant électronique (3).

5. Procédé de fabrication selon l'une des revendications précédentes, dans lequel le décalage prédéterminé (D_{zc}) présente une première amplitude de décalage (Aₓ) et/ou une deuxième amplitude de décalage (A_{y}), comprises entre 1 µm et 100 µm.

6. Procédé de fabrication selon l'une des revendications précédentes, dans lequel chaque zone de champ (ZC) comprend un champ (2) unique.

7. Procédé de fabrication selon l'une des revendications précédentes, dans lequel chaque champ (2) comprend un unique composant électronique (3).

8. Procédé de fabrication selon l'une des revendications précédentes, dans lequel les composants électroniques (3) comprennent des transistors à haute mobilité électronique à base de matériaux III-N.

## Patentansprüche

1. Verfahren zur Herstellung einer Anordnung von elektronischen Bauteilen (3) auf einer Vorderseite eines Halbleitersubstrats (1), das eine Vielzahl von Feldbereichen (ZC) aufweist, wobei jeder Feldbereich (ZC) mindestens ein Feld (2) aufweist und jedes Feld (2) mindestens ein elektronisches Bauteil (3) aufweist, wobei das Verfahren eine Vielzahl von Photolithographieschritten aufweist, um einen Stapel von Schichten auszubilden, die jedes elektronische Bauteil (3) bilden, darunter einen Schritt der Photolithographie zum Öffnen der Kontakte der elektronischen Komponenten (3), wobei jeder Photolithographieschritt eine Maskierungsebene (Lₙ) definiert und das Anlegen einer Maske (mₙ) nacheinander auf jedes Feld (2) in einer Photolithographieanlage aufweist, wobei die Positionierung der Maske (mₙ) auf jedem Feld (2) in Bezug auf eine Referenzmaskierungsebene (L_{ref}) erfolgt, wobei eine der Masken (mₙ) als Identifikationsmaske (mᵢ) designiert wird;
wobei das Herstellungsverfahren **dadurch gekennzeichnet ist, dass:**
- die Maske, die im Photolithographieschritt für die Öffnung der Kontakte verwendet wird, der Identifikationsmaske (mᵢ) entspricht;
- bei dem Photolithographieschritt, der eine Maskierungsebene (Lᵢ) definiert, die mit der Identifikationsmaske (mᵢ) assoziiert ist, wird die Maske (mᵢ) mit einem vorbestimmten Versatz (D_{zc}) in Bezug auf die Referenzmaskierungsebene (L_{ref}) positioniert, wobei der Versatz (D_{zc}) für jeden Feldbereich (ZC) unterschiedlich ist,
- das/die elektronische(n) Bauelement(e) (3) eines Feldbereichs (ZC) ein Identifikationselement aufweisen, das als ein vorbestimmter Versatz (D_{zc}) zwischen einem auf der Referenzmaskenebene (L_{ref}) definierten Muster und einem auf der Identifikationsmaskenebene (Lᵢ) definierten Muster erscheint.

2. Herstellungsverfahren gemäß dem vorhergehenden Anspruch, wobei der vorbestimmte Versatz (D_{zc}) zwischen einem minimalen optisch erkennbaren Versatz und einem maximalen Versatz variiert, der wahrscheinlich die Leistung der elektronischen Komponenten verschlechtert.

3. Herstellungsverfahren gemäß dem vorhergehenden Anspruch, wobei der vorbestimmte Versatz (D_{zc}) eine erste Versatzamplitude (Aₓ) entlang einer ersten Achse (x) einer Hauptebene (x, y) parallel zur Vorderseite des Substrats (1) und/oder eine zweite Versatzamplitude (A_{y}) entlang einer zweiten Achse (y) der Hauptebene (x, y) aufweist.

4. Herstellungsverfahren gemäß einem der vorhergehenden Ansprüche, wobei die Referenzmaskenebene (L_{ref}) durch einen photolithographischen Schritt vor dem Schritt zum Öffnen von Kontakten zum Bilden einer letzten Metallisierungsschicht des Stapels von Schichten, die jedes elektronische Bauelement (3) bilden, definiert wird.

5. Herstellungsverfahren gemäß einem der vorhergehenden Ansprüche, wobei der vorbestimmte Versatz (D_{zc}) eine erste Versatzamplitude (Aₓ) und/oder eine zweite Versatzamplitude (A_{y}) im Bereich von 1 µm bis 100 µm aufweist.

6. Herstellungsverfahren gemäß einem der vorhergehenden Ansprüche, wobei jeder Feldbereich (ZC) ein einzelnes Feld (2) aufweist.

7. Herstellungsverfahren gemäß einem der vorhergehenden Ansprüche, wobei jedes Feld (2) ein einzelnes elektronisches Bauelement (3) aufweist.

8. Herstellungsverfahren gemäß einem der vorhergehenden Ansprüche, wobei die elektronischen Bauelemente (3) Transistoren mit hoher Elektronenbeweglichkeit auf der Basis von III-N-Materialien aufweisen.

## Claims

1. Method of manufacturing an assembly of electronic components (3) on a front surface of a semiconductor substrate (1) comprising a plurality of field areas (ZC), each field area (ZC) comprising at least one field (2) and each field (2) comprising at least one electronic component (3), the method comprising a plurality of photolithography steps to form a stack of layers forming each electronic component (3), among which a step of photolithography for the opening of contacts of the electronic components (3, each photolithography step defining a mask level (Lₙ) and comprising the application of a mask (mₙ) successively on each field (2) in photolithography equipment, the positioning of said mask (mₙ) on each field (2) being performed relative to a reference mask level (L_{ref}), one of the masks (mₙ) being designated as identification mask (mᵢ);
the manufacturing method being **characterized in that:**
- the mask applied at the photolithography step for the opening of the contacts corresponds to the identification mask (mᵢ);
- at the photolithography step defining a mask level (Lᵢ) associated with the identification mask (mᵢ), said mask (mᵢ) is positioned with a predetermined offset (D_{zc}) with respect to the reference mask level (L_{ref}), the offset (D_{zc}) being different for each field area (ZC),
- the electronic component(s) (3) of a field area (ZC) exhibit an identification element appearing as a predetermined offset (D_{zc}) between a pattern defined at the reference mask level (L_{ref}) and a pattern defined at the identification mask level (Lᵢ).

2. Manufacturing method according to the foregoing claim, wherein the predetermined offset (D_{zc}) varies between a minimum optically-detectable offset and a maximum offset likely to degrade the performance of the electronic components.

3. Manufacturing method according to the foregoing claim, wherein the predetermined offset (D_{zc}) comprises a first offset amplitude (Aₓ) along a first axis (x) of a main plane (x, y) parallel to the front surface of the substrate (1), and/or a second offset amplitude (A_{y}) along a second axis (y) of the main plane (x, y).

4. Manufacturing method according to the foregoing claim, wherein the reference mask level (L_{ref}) is defined by a photolithography step, prior to that for the opening of contacts, for the forming of a last metallization layer of the stack of layers forming each electronic component (3).

5. Manufacturing method according to one of the foregoing claims, wherein the predetermined offset (D_{zc}) has a first offset amplitude (Aₓ) and/or a second offset amplitude (A_{y}), in the range from 1 µm to 100 µm.

6. Manufacturing method according to one of the foregoing claims, wherein each field area (ZC) comprises a single field (2).

7. Manufacturing method according to one of the foregoing claims, wherein each field (2) comprises a single electronic component (3).

8. Manufacturing method according to one of the foregoing claims, wherein the electronic components (3) comprise high electron mobility transistors based on III-N materials.
